# EUROPEAN PATENT APPLICATION

(11) **EP 3 109 964 A1**
(43) Date of publication of application: **28.12.2016**
(21) Application number: 15174000.8
(22) Date of filing: 26.06.2015
(51) Int. Cl.: H02J 1/00, H02J 4/00, H02H 7/26

(54) **DC GRID**

(71) Applicant: Siemens Aktiengesellschaft, 80333 München (DE)
(72) Inventor: Aagesen, Ketil, 7045 Trondheim (NO); Valen, Alf Olav, 7058 Jakobsli (NO)
(74) Representative: Maier, Daniel Oliver

(57) **Abstract**

A DC grid for an offshore structure (81, 91) comprises at least four switchboards (21, 22, 54, 55), each switchboard comprising at least three connections (60, 61, 38) to other switchboards (21, 22, 54, 55). The grid further comprises a plurality of energy sources (80) on the offshore structure, at least one energy source being associated with one of the switchboards; and a plurality of energy consumers (85), at least one of the energy consumers being associated with one of the switchboards.

## Description

This invention relates to a DC grid, such as a grid for a vessel or platform, in particular for low or medium voltage.

DC grids, independent of a shore supply and suitable for installation on a vessel, drilling rig, platform or other type of offshore structure have been developed over the last few years. In order to obtain regulatory approval for an offshore DC grid in such applications, there must be a certain level of redundancy to ensure minimum performance in the event of failure.

In accordance with a first aspect of the present invention a DC grid for an offshore structure comprises at least four switchboards, each switchboard comprising at least three connections to other switchboards; a plurality of energy sources on the offshore structure, at least one energy source being associated with one of the switchboards; and a plurality of energy consumers, at least one of the energy consumers being associated with one of the switchboards.

Reliability in the event of failure is increased by providing at least three connections from each switchboard to other switchboards, so that in the event of a fault of failure in one switchboard, or in one generator, or consumer, directly connected to one switchboard, other generators or consumers or other switchboards are already connected.

The connections between switchboards may be made with a permanent connection at one end and a switch at the other end, which is separable in the event of a fault or failure, but preferably, each connection comprises a switch at both ends of the connection for separating the switchboards from one another;

Preferably, the switchboards are provided in at least three sections, each section being physically separated from one another.

In some cases, each switchboard is in a separate section. In either case, the physical separation improves resistance to failures caused by fire or flood events.

In one embodiment, at least one of the switchboard sections is located on a separate offshore structure.

By using switchboard sections on two separate offshore structures, further resilience to fire or flood events is provided.

In one embodiment, the grid further comprises secondary switchboards, each secondary switchboard comprising only one or two connections to other switchboards.

This is a cost effective means of providing further risk reduction.

Although not every switchboard has a direct connection to an energy source, in one embodiment at least one section comprises at least one switchboard, at least one energy source and at least one consumer.

Preferably, the energy sources comprise at least one of a generator, stored electrical energy source, or AC energy source supplied via a transformer.

Preferably, the consumers comprise one of thrusters, battery or capacitor based energy stores.

Preferably, at least one of the energy sources or the energy consumers comprise a switchable connection to the switchboard.

Preferably, the switches comprise semiconductor switches.

This allows for fast switching to isolate faulty equipment, so the switches can be normally closed.

A method of supplying energy to an energy consumer on an offshore structure, the method comprising providing switchable connections between a first switchboard and three or more further switchboards; providing an energy source on an offshore structure and connecting the energy source to at least one of the switchboards to form a DC grid; and connecting an energy consumer to at least one of the switchboards, whereby energy is provided from the energy source to the consumer through the connections when the switches are closed.

Preferably, the method further comprises detecting a fault in one of the switchboards; and opening all connections to that switchboard to isolate that switchboard from any other switchboard.

Preferably, the method further comprises detecting a fault in one of the energy sources or consumers and opening all connections between that energy source or that consumer and its switchboard.

Preferably, the method further comprises connecting at least one of the switchboards to a further switchboard located on a separate offshore structure.

Preferably, the method further comprises supplying the switchboard with power from the separate offshore structure.

Preferably, the offshore structures comprises one of a vessel, offshore platform, or drilling rig.

An example of a DC grid in accordance with the present invention will now be described with reference to the accompanying drawings in which:
Figure 1 illustrates an example of a conventional DC grid with a single bus tie in a single section;
Figure 2 illustrates an example of a conventional DC grid with serial bus ties in two sections;
Figure 3 illustrates a first example of a DC grid according to the present invention, with three sections;
Figure 4 illustrates a second example of a DC grid according to the present invention, with six sections;
Figure 5 is an alternative view of the DC grid of Fig.4;
Figure 6 illustrates a third example of a DC grid according to the present invention, with four sections;
Figure 7 illustrates a fourth example of a DC grid according to the present invention, with eight sections;
Figure 8 is a flow diagram illustrating operation of an example of a DC grid according to the present invention; and,
Figure 9 illustrates a typical layout on a vessel, or offshore structure or group of vessels or offshore structures, to which the present invention may be applied;

Groups of components comprising at least one power source, one switchboard and one consumer may be viewed as islands, whether on the same vessel or structure, or on a different one. A DC grid formed by interconnection of a plurality of islands improves reliability, as a fault in an energy source of one island may require that source to be isolated, but the consumer can still be fed, through its switchboard, from an energy source of another island in the grid. Conventionally, DC island grids comprise two or more islands, or sections, typically three or four sections, which may be connected together in series. These may be arranged such that in normal operation, the connections, bus breakers, between the sections are open, due to difficulties in maintaining safe operation in other sections, if a fault occurs in one section when the sections are connected, so only in the case of a fault will a connection close to provide a supply from a neighbouring island.

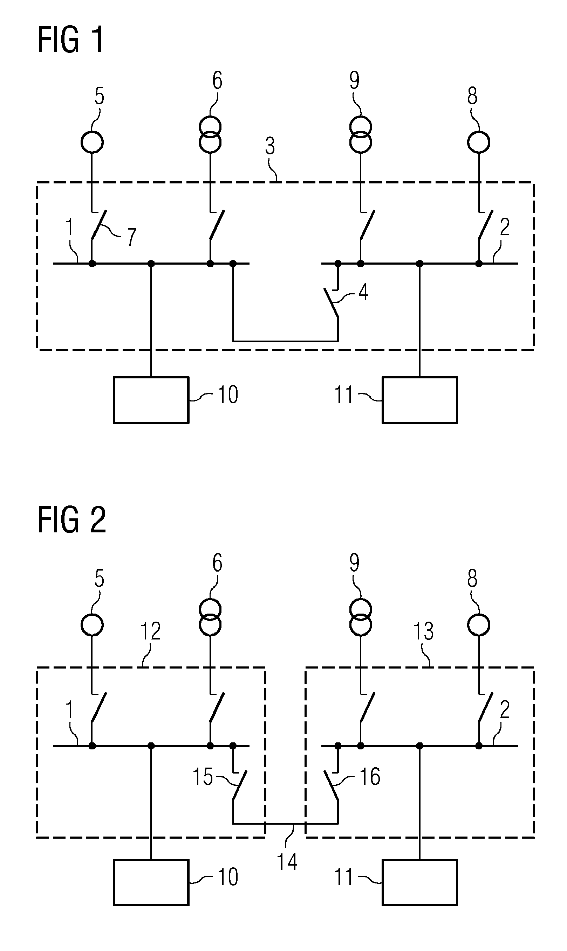

Fig.1 illustrates an example of a conventional DC grid with two switchboards 1, 2 in one section 3, with one bus tie 4 between the switchboards. In normal operation, the bus tie 4 is open, i.e. the switch is open, but if, for example, an energy source, such as a generator 5, or AC transformer 6, supplying switchboard 1 becomes faulty, then that energy source may be disconnected from the switchboard for example by opening switch 7 and the switch on the bus tie 4 is closed, so that switchboard 1 receives power from generator 8, or via AC transformer 9, via switchboard 2 and is still able to feed consumer 10. Consumer 11 is also supplied from the energy sources of switchboard 2. This solution is standard on many vessels. For vessels or drilling units where there is only one equipment room, this arrangement is often extended by adding a further single bus tie and a further switchboard in series (not shown), on the other side of the switchboard 2, still within the same section 3.

Fig. 2 illustrates a modification of Fig.1, common in vessels and drilling units, using two switchboards 1, 2 in separate sections 12, 13, with a serial bus tie 14 between them. This improves safety, as fire or flooding, or other such damage in one section does not inevitably affect the other section. In the case of a fault in one section 12, switches 15, 16 on the bus tie 14 may be closed to allow power to be supplied to section 12 from the energy sources 8, 9 in the other section 13, via the switchboard 2. As with the Fig.1 example, where switchboards are arranged in different zones, or sections, this arrangement may be extended by adding a further serial bus tie connecting to a further section having a further switchboard in series (not shown), on the other side of the switchboard 2.

A combination of the Fig.1 and Fig.2 examples is also possible, with single bus ties between two switchboards in each section and also a serial bus tie connecting the switchboards of one section to those of another section, so that a switchboard within the same section or one in the other section can be used to route power from other energy sources in the event of a fault.

In some cases, for example, as described in EP2654157, the sections may be connected in a ring configuration, with the connections normally closed. This allows for part of the ring to be isolated in case of a fault by opening some connections, but the remainder of the consumers on the ring are able to be supplied, from other generators on the ring. However, this requires a generator ride through system to limit excitation field current to the generators, in the case of a fault.

Offshore vessels and structures are subject to type approval from appropriate certification bodies and in order to obtain a high environmental regulatory number (ERN) sections have to be isolated from one another, to prevent the spread of fire or flooding from one section to another, as well as being designed so that each section is able to be electrically isolated from another section. There are also requirements for redundancy, i.e. provision of multiple units of the same type, for example parallel switchboards and parallel thrusters, in case of failure. All of these requirements add to the cost of vessel or structure.

The present invention addresses the regulatory requirements more efficiently than prior art arrangements by providing multiple interconnections between switchboard sections. At least three interconnections are provided, but four or more may be used in some cases. These interconnections are made using fast acting semiconductor switches, for example able to disconnect in around 10 microseconds, as compared with a conventional switch which can take 20 ms to 30 ms. For example switches may be used as described in WO2012038101. The multiple interconnections of the present invention give improved flexibility in case of failure in one of the components and a high ERN. Although the design is aimed at addressing the particular problems faced during offshore operation of the vessel, the protection offered by the DC grid of the present invention may be useful even when the vessel is in harbour, e.g. for manoeuvring, replenishing, or loading.

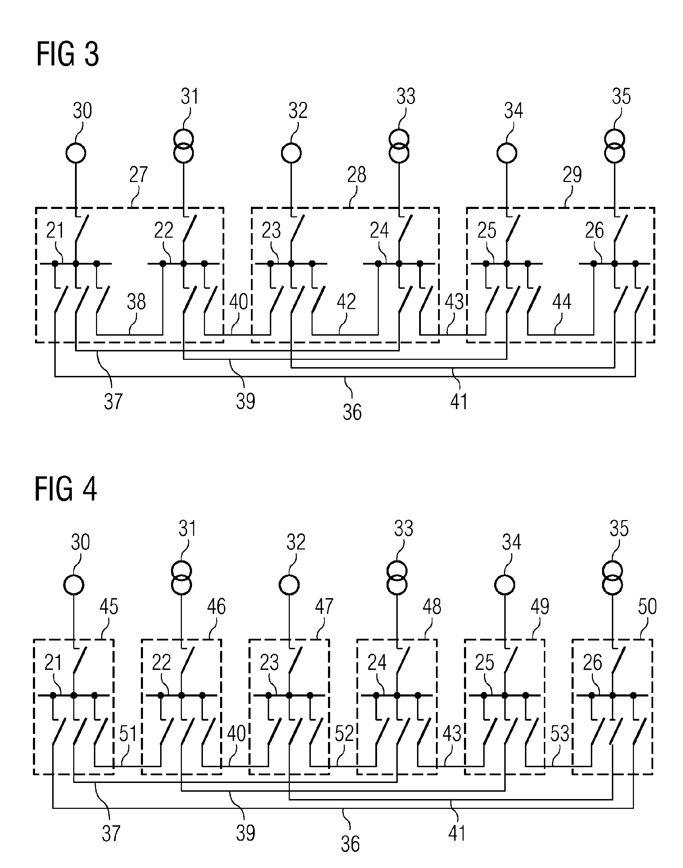

Fig.3 illustrates a first example of a DC grid according to the present invention. The DC grid 20 comprises at least four switchboard sections 21 to 26. In this example, each section 27, 28, 29 has two switchboards, but a section may have more, or fewer, switchboards. For this example, within one section, one switchboard is connected to another by a single bus tie 38, 42, 44. Each switchboard is shown with a connection to an energy source 30 to 35, which may be of different types. For example the energy source may be a generator, or AC energy received via a transformer, rectified to DC, either in the switchboard, or by a separate rectifier module connected to the generator, or other types of energy source may be used, such as stored energy, e.g. batteries (not shown), or capacitors. However, modifications, such as multiple energy sources per switchboard, of different types, or some switchboards having no direct connection to an energy source, but relying on obtaining energy from another switchboard with which a connection is normally closed, are also possible. Typically, each switchboard of the DC grid has a direct connection to at least one consumer, but only half or two thirds of switchboards have a direct connection to an energy source. However, the provision of generators or consumers for each switchboard may be adapted to the customer requirements.

Although not shown in detail in the figures, the switchboard section may include one or more power generation inputs via an alternator or a rectifier, or may use a transformer feed with a rectifier. The power may be supplied to the consumers through a DC to AC converter for feeding an AC motor, or via a DC to AC converter for feeding other AC loads, with or without transformers. The power may be fed to DC energy storage with a battery, with or without a converter, or to DC energy storage with a capacitor, with or without a converter, or the power may be supplied via an ordinary DC feeder to loads, with or without a converter. Each connection to the switchboard from outside the section has a breaker for protection and/or isolation which is within the section. Connections between switchboards within the same section may have either one or two breakers on the connection.

From each switchboard, there are three or more interconnections 36 to 44. Each interconnection goes to another switchboard, which may be in the same section, or in a different section. Preferably, at least one of the switchboards is in a different section, as this provides greater protection against certain types of failures, such as failure due to fire or flood in one section. Typically, interconnections 36, 37, 39, 40, 41, 43 between sections use serial bus ties, rather than the single bus ties 38, 42, 44 used within a section. If there is a substantial failure in one section, the remaining switchboards are not affected, so with the arrangement shown in Fig.3, a maximum of one third of the switchboards would be out of use. For clarity, the connections to the consumers supplied via each switchboard are not shown in this figure. In general, at least one consumer is supplied by each switchboard, but in some cases, the switchboard may be used only to provide a back up supply to consumers connected to other switchboards, for example in the event of a failure of a primary energy source of one of the other switchboards.

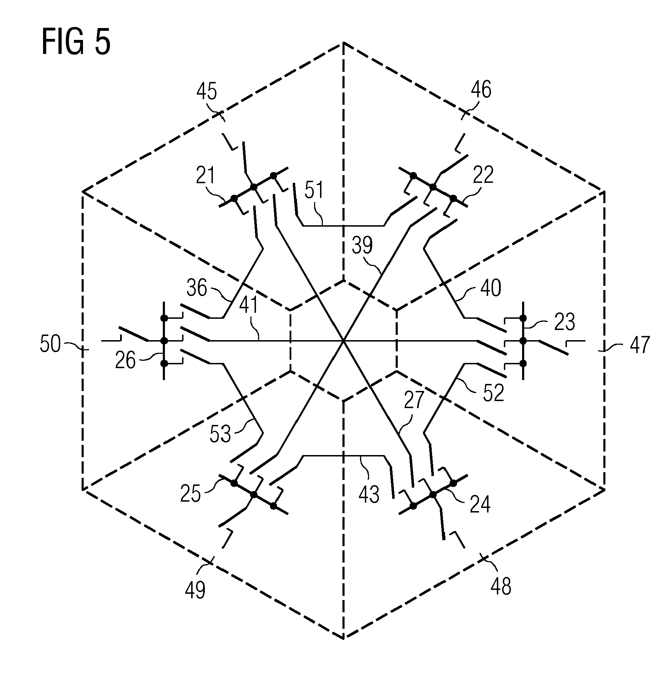

Fig.4 illustrates another example of the present invention. In this case, each of the switchboards 21 to 26 is in its own section 45 to 50, so physically separated from any other switchboard to which it is connected. As before, each switchboard has multiple interconnections 36, 37, 51, 39, 40, 41, 52, 43, 53 to other switchboards. Three interconnections are shown for each switchboard in this example, but more interconnections are possible, up to the point where one switchboard is connected to all other switchboards in the grid. However, there is a trade-off between adding reliability and adding cost and complication, so three or four interconnections are preferred. For this example, a substantial failure in one section only takes down one sixth of the total number of switchboards in the grid. An alternative view of the arrangement is shown in Fig.5 displaying the interconnection principal between switchboard sections.

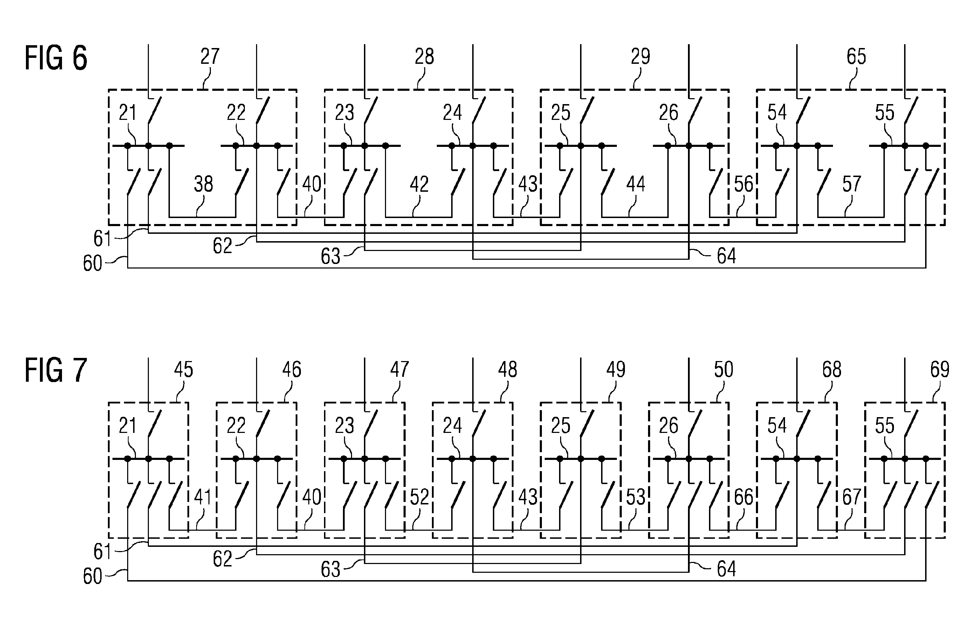

Fig.6 illustrates a larger grid with four sections 27, 28, 29, 65. The arrangement of the first three sections is as in Fig.3. Between switchboards 21, 22 in the same section 27, a bus tie 38 with a single breaker is used. Between switchboards 22, 23 in different sections 27, 28 serial bus ties 40 with breakers at each end are used. The additional section 65 also has two switchboards 54, 55 connected by a single bus tie 57. The adjacent switchboards 26, 54 in sections 29, 65 are connected by a serial bus tie 56. As well as the bus ties between adjacent switchboards in the figure, serial bus tie interconnections 60 to 64 are provided between switchboards 21 and 55, 21 and 54, 22 and 55 and 23 and 25 respectively. With this arrangement, with four sections, each having three interconnections, a substantial failure may take down only one quarter of the switchboards.

The example of Fig.7 shows an arrangement which differs from Fig.6 in the same way that the example of Fig.4 differs from the example of Fig.3. The same switchboards are provided as in Fig.6, but instead of four sections 27, 28, 29, 65 there are now eight sections 45 to 50, 68 and 69, one for each switchboard 21 to 26, 54 and 55. Bus ties 38, 42, 44, 57 have been replaced by serial bus ties 51, 52, 53 and 67. The other interconnections are the same as in Fig.6 meaning that all interconnections between switchboards are serial bus ties, with breakers at each end. For this example, with eight sections and at least three interconnections per switchboard, a substantial failure may take down only one eighth of the switchboards. The examples given do not exclude the use of more than three interconnections, but each additional interconnection adds cost and complexity, so three interconnections are preferred to achieve the desired improvement in operational reliability at an acceptable cost.

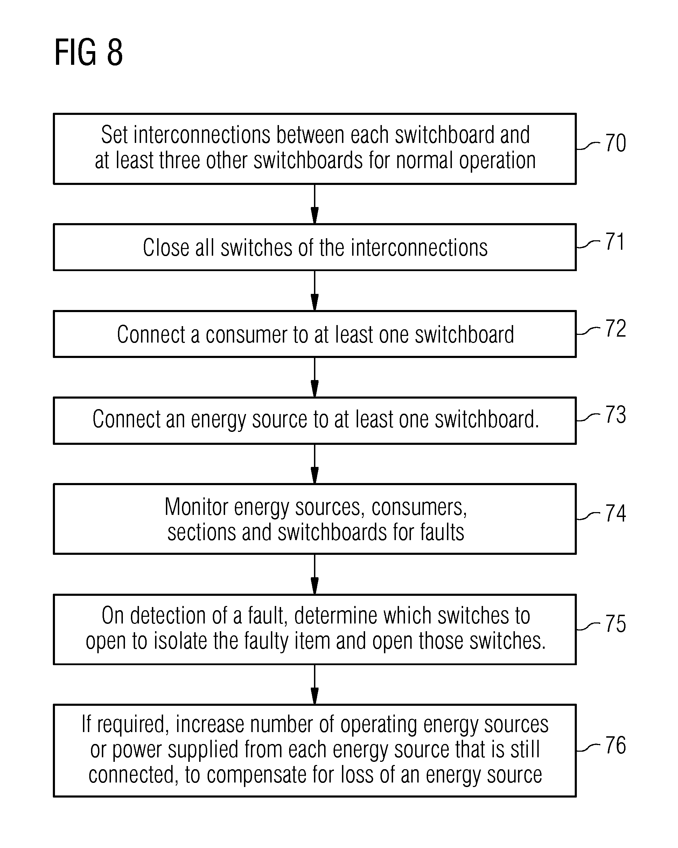

Fig.8 is a flow diagram illustrating an example of a method of supplying energy to a consumer on an offshore structure. The grid is constructed by providing 70 at least three interconnections between a primary switchboard and any other switchboard. When switches of these interconnections are closed 71, in normal operation, at least one consumer is connected 72 to one of the switchboards in the grid and at least one energy source is connected 73 to one of the switchboards in the grid. In normal operation, any consumer, connected to any of the switchboards connected by the interconnections, can receive power from any energy source connected to one of the switchboards. Thus, not every switchboard in the grid needs a direct connection to an energy source, with all of the associated cabling and construction issues that this entails. The energy source is typically on an offshore structure or vessel, but does not have to be on the same offshore structure or vessel as the consumer. Supply from another offshore structure or vessel may be via a DC link. Incorporating a separate offshore structure or vessel in the DC grid assists with providing security of supply as fire or flood occurring on one structure or vessel is less likely to spread to another switchboard, consumer or generator, if those are on a different offshore structure or vessel.

The energy sources, consumers, switchboards and segregated sections housing any of these are monitored 74 by a central controller and in the event of a fault in any part, the controller may send a signal 75 to a switch on one or more interconnections, to open the switch and so isolate the faulty part. In addition, the controller is able to instruct 76 an increase in the power output of remaining energy sources, or even cause standby energy sources which had not been operating to be activated, to compensate for a loss of an energy source. Similarly, if a consumer fails and the energy requirement is reduced, or needs to be redirected, the controller is able to adapt the energy supply accordingly.

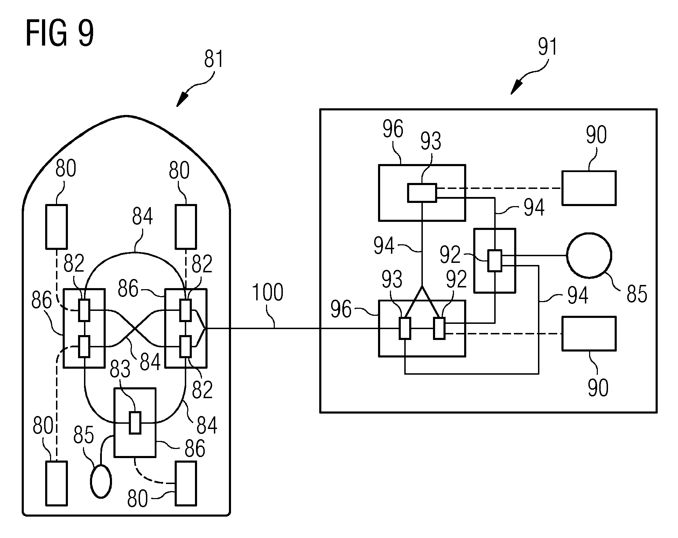

Fig.9 is a block diagram illustrating a layout for elements of a DC grid according to the invention where at least part of the grid is on a separate offshore structure or vessel. For clarity the number of consumers shown is limited. In this example, a vessel 81 has five switchboards 82, 83 in three sections 86. Primary switchboards 82 have interconnections 84 to at least three other switchboards, whereas secondary switchboards 83 may have only two interconnections to other switchboards. Energy sources 80 may be connected to primary or secondary switchboards 82, 83, but not all switchboards have a direct connection to an energy source. Consumers 85 are connected to switchboards in some sections 86, but again, not every switchboard must have a consumer directly connected. In this example, the DC grid may be extended by a DC link 100 to other switchboards, 92, 93 in sections 96 on an offshore platform 91. Energy sources 90 are connected, directly or indirectly, to the switchboards 92, 93 and consumers are connected to some or all of the switchboards, as required.

Embodiments with a minimum of four primary switchboards and three interconnections per primary switchboard, in at least two sections, are possible, but three or more sections, physically separated and able to be isolated from other sections for a period of time, in case of fire or flood, are preferred. In particular, having at least one primary switchboard in a section which is not close to other sections, or which is even on a separate offshore structure, reduces the impact of a failure. However, additional secondary switchboard sections may be provided which have only one or two interconnections, as this saves in terms of cost, whilst improving operational effectiveness. The interconnections define subsidiary closed rings, so that only limited current is isolated and as many consumers as possible are fed from the remaining energy sources in the grid. Semiconductor switches enable fast detection of faults and separation of contacts, so that only a small part of the grid and its energy sources, or consumers, are disconnected. The invention provides important improvements on offshore platforms or vessel, where availability is a particular issue, particularly for powering thrusters to keep a vessel on station, or powering consumers directly involved in drilling operations to maintain production.

The design of DC grid contributes towards a high ERN (Enhanced Reliability Number) in an offshore DC Grid, whether on a vessel, platform or drilling equipment. The solution is applicable over a wide range of voltages, but is particularly applicable to low voltage and medium voltage offshore DC grids. For example for low voltages up to 1000V AC, 1500V DC and medium voltages up to 36KV AC, 50KV DC, but the invention may also be applied at high voltages in the region of 500KV. There is increased operational safety due to multiple switchboard interconnections. The DC grid is independent of synchronization and therefore gives a fast voltage ramp up to loads. There is improved discrimination with fast acting semiconductor switches and there is high utilization and distribution of energy flow.

A further benefit of the invention is that by sharing an energy source over a number of consumers, the energy source, in particular a generator, can be run at its most efficient speed, which if it only directly supplied its own consumers, could lead to many generators running inefficiently. Additional generators would only be brought on-line as required, reducing fuel consumption and wear and tear on the generator. In some cases, a secondary switchboard may be provided, with fewer interconnections, which only serves as a back-up for an energy source, or consumer.

## Claims

1. A DC grid for an offshore structure, the grid comprising at least four switchboards, each switchboard comprising at least three connections to other switchboards; wherein the grid further comprises a plurality of energy sources on an offshore structure, at least one energy source being associated with one of the switchboards; and a plurality of energy consumers, at least one of the energy consumers being associated with one of the switchboards.

2. A DC grid according to claim 1, wherein each connection comprises a switch at both ends of the connection for separating the switchboards from one another;

3. A DC grid according to claim 1 or claim 2, wherein the switchboards are provided in at least three sections, each section being physically separated from one another.

4. A DC grid according to claim 3, wherein at least one section comprises at least one switchboard, at least one energy source and at least one consumer.

5. A DC grid according to any preceding claim, wherein at least one of the switchboard sections is located on a separate offshore structure.

6. A DC grid according to any preceding claim, wherein the grid further comprises secondary switchboards, each secondary switchboard comprising only one or two connections to other switchboards.

7. A DC grid according to any preceding claim, wherein the energy sources comprise at least one of a generator, stored electrical energy source, or AC energy source supplied via a transformer.

8. A DC grid according to any preceding claim, wherein the consumers comprise one of thrusters, battery or capacitor based energy stores.

9. A DC grid according to any preceding claim, wherein at least one of the energy sources or the energy consumers comprise a switchable connection to the switchboard.

10. A DC grid according to any preceding claim, wherein the switches comprise semiconductor switches.

11. A method of supplying energy to an energy consumer on an offshore structure, the method comprising providing switchable connections between a first switchboard and three or more further switchboards; providing an energy source on an offshore structure and connecting the energy source to at least one of the switchboards to form a DC grid; and connecting an energy consumer to at least one of the switchboards, whereby energy is provided from the energy source to the consumer through the connections when the switches are closed.

12. A method according to claim 11, wherein the method further comprises detecting a fault in one of the switchboards; and opening all connections to that switchboard to isolate that switchboard from any other switchboard.

13. A method according to claim 11 or claim 12, wherein the method further comprises detecting a fault in one of the energy sources or consumers and opening all connections between that energy source or that consumer and its switchboard.

14. A method according to any of claims 11 to 13, wherein the method further comprises connecting at least one of the switchboards to a further switchboard located on a separate offshore structure.

15. A method according to claim 14, wherein the method further comprises supplying the switchboard with power from the separate offshore structure.

16. A method according to any of claims 11 to 15, wherein the offshore structures comprise one of a vessel, offshore platform, or drilling rig.
